# EUROPEAN PATENT APPLICATION

(11) **EP 2 088 573 A2**
(43) Date of publication of application: **12.08.2009**
(21) Application number: 09152152.6
(22) Date of filing: 05.02.2009
(51) Int. Cl.: G09G 3/22

(54) **Drive circuit of display panel and display apparatus**

(30) Priority: 06.02.2008 JP 2008026462; 06.01.2009 JP 2009000735
(71) Applicant: Canon Kabushiki Kaisha, Tokyo 146-8501 (JP)
(72) Inventor: Shino, Kenji, Tokyo Tokyo 146-8501 (JP); Noine, Yasukazu, Minato-ku, Tokyo (JP)
(74) Representative: TBK-Patent

(57) **Abstract**

A drive circuit, which drives a display panel having wirings and display devices to be connected to the wirings, has first driving means that allows a potential of the wirings to transit toward the first potential, second driving means that maintains the potential of the wirings at the first potential, and a control circuit that outputs the control signal for controlling the second driving means according to an output of the first driving means. As a result, a plurality of driving means can be controlled at appropriate timing in a simple structure.

## Description

### BACKGROUND OF THE INVENTION

### Field of the Invention

The present invention relates to a drive circuit of a display panel and a display apparatus.

### Description of the Related Art

Flat display apparatuses such as electron beam display apparatuses, plasma display apparatuses and organic EL display apparatuses are known. Such a kind of display apparatuses has a display panel (matrix panel) where a lot of display devices are arranged in a matrix pattern, and a drive circuit which drives the display devices.

Japanese Patent Application Laid-Open No. 2004-4429 discloses a drive circuit of a matrix panel. This drive circuit uses a plurality of MOSFETs whose ON-state resistance varies as a driving means for applying a predetermined voltage to wirings. In order to suppress wave form disturbance, the plurality of MOSFETs is turned on sequentially.

Conventionally, ON/OFF states of the MOSFETs are controlled individually by control signals output from a logic circuit. In this constitution, however, it is difficult to appropriately control ON/OFF timing of the respective MOSFETs to shift each ON periods little by little. Further, a level shifter is necessary for each MOSFET, and thus the circuit becomes complicated and large.

### SUMMARY OF THE INVENTION

The present invention provides a drive circuit of a display panel and a display apparatus which can control a plurality of driving means at appropriate timing in a simple constitution.

The present invention in its first aspect provides a drive circuit of a display panel as specified in claims 1 to 8.

The present invention in its second aspect provides a display apparatus as specified in claim 9.

According to the present invention, provided are the drive circuit of the display panel and the display apparatus which can control a plurality of driving means at appropriate timing in a simple constitution.

### BRIEF DESCRIPTION OF THE DRAWINGS

FIG. 1 is a diagram illustrating a circuit configuration of a buffered switch according to the first embodiment;
FIG. 2 is a block diagram illustrating a scan driving unit according to the first embodiment;
FIG. 3 is a diagram illustrating a circuit configuration of a self switch;
FIG. 4A is a plan view illustrating an image display apparatus, and FIG. 4B is a cross-sectional view of the image display apparatus;
FIG. 5 is a diagram illustrating a circuit configuration of the buffered switch according to the second embodiment;
FIG. 6 is a block diagram illustrating the scan driving unit according to the second embodiment;
FIG. 7 is a diagram illustrating a circuit configuration of a conventional buffered switch;
FIG. 8 is a diagram illustrating an example of waveform disturbance;
FIG. 9 is a diagram explaining an operation of the circuit in FIG. 7; and
FIG. 10A is a plan view illustrating a constitution which drives a liquid crystal backlight, and FIG. 10B is a cross-sectional view thereof.

### DESCRIPTION OF THE EMBODIMENTS

An embodiment of the present invention is described below with reference to the drawings. In all the drawings of the embodiments, like or corresponding portions are denoted by like symbols.
The present invention can be applied preferably to an image display apparatus which has a display panel (matrix panel) where a lot of display devices are arranged in a matrix pattern. Examples of such a kind of image display apparatuses are electron beam display apparatuses, plasma display apparatuses and organic EL display apparatuses. In an electron beam display apparatus, a cold cathode device such as an FE type electron-emitting device, an MIM type electron-emitting device or a surface conduction electron-emitting device is preferably used.

### <First Embodiment>

### (Constitution of Image Display Apparatus)

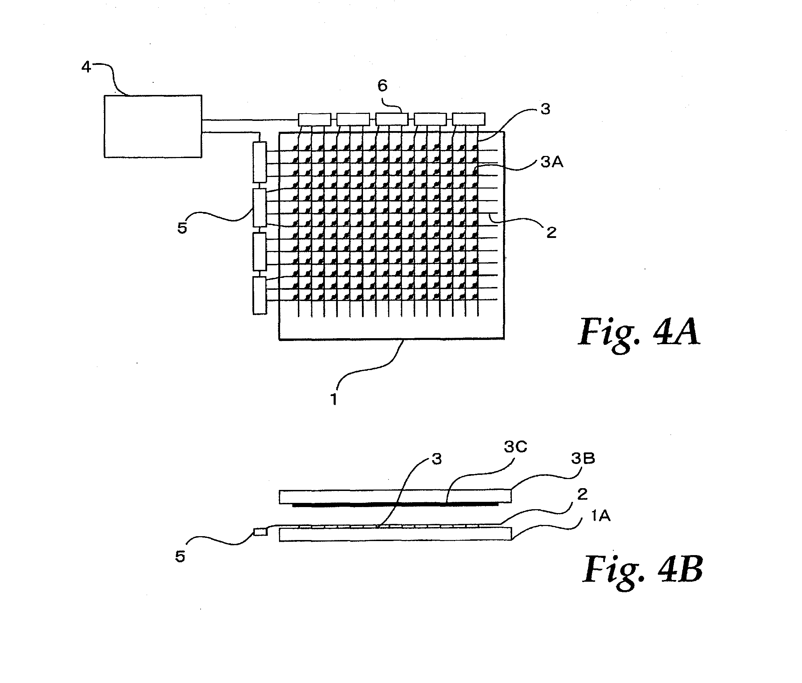

FIGS. 4A and 4B are diagrams illustrating a constitution of the image display apparatus, FIG. 4A is a plan view, and FIG. 4B is a cross-sectional view. The image display apparatus includes a matrix panel (display panel) 1, a control unit 4, a scan driving unit 5 and a modulation driving unit 6. The scan driving unit 5 and the modulation driving unit 6 are composed of ICs (integrated circuits). The matrix panel 1 has a rear plate 1A on which a plurality of electron-emitting devices 3A (also as electron sources) is arranged, and a face plate 3B on which a phosphor 3C is arranged. Surface conduction electron-emitting devices are used as the electron-emitting devices 3A. The electron-emitting devices on the rear plate 1A are matrix-driven through scanning wirings 2 and modulation wirings 3. The respective scanning wirings 2 are connected to output terminals of the scan driving unit 5 via a flexible printed wiring board (FPC) or the like. The respective modulation wirings 3 are connected to output terminals of the modulation driving unit 6 via FPC or the like.

The control unit 4 controls the scan driving unit 5 and the modulation driving unit 6, and a driving voltage of several dozen bolts is applied between the scanning wirings 2 and the modulation wirings 3. As a result, electrons are emitted from the electron-emitting devices 3A. A high voltage of several kV to several dozen kV is applied to the face plate 3B. The electrons emitted from the electron-emitting devices 3A are attracted to the face plate 3B, and collide against the phosphor 3C. As a result, light emission can be obtained. Brightness at this time is determined by an amount of the electrons colliding against the phosphor 3C in a predetermined period. Therefore, the brightness can be controlled by a value of the driving voltage or an applying period or both of them. As a result, gradation display is enabled.

In the first embodiment, the control unit 4 controls voltages of a scanning signal to be applied to the scanning wirings 2 and a modulation signal to be applied to the modulation wirings 3, so that various videos are displayed. The brightness obtained by light emission from the phosphor 3C is, as described previously, determined by the driving voltage of the electron-emitting devices (a potential difference between the scanning signal and the modulation signal). Therefore, in order to obtain accurate luminance characteristics, stabilization of the driving voltage of the electron-emitting devices 3A, namely, prevention of waveform disturbance of the driving voltage (overshoot, undershoot, ringing, and the like) becomes important.

### (Driving Unit)

The scan driving unit 5 is a drive circuit which selects one or a plurality of scanning wirings 2. The scan driving unit 5 applies a selection potential to the scanning wirings 2 to be selected, and applies a non-selection potential to the other scanning wirings 2. The scanning wirings 2 to be selected are sequentially switched, so that scanning in a vertical direction is realized. The scan driving unit 5 is composed of integrated circuits. If one integrated circuit scans all the scanning wirings, a difference in path lengths from the integrated circuit to the respective scanning wirings becomes large. In order to solve this problem, a plurality (four) of integrated circuits are used so as to compose the scan driving unit 5 in the first embodiment.

The modulation driving unit 6 is a drive circuit which applies a modulation signal modulated based on an input image signal to the modulation wirings 3. The modulation signal is generated from an output of single or a plurality of constant voltage power sources. The modulation driving unit 6 is also composed of several integrated circuits (five integrated circuits in this embodiment).

### (Modulation Signal)

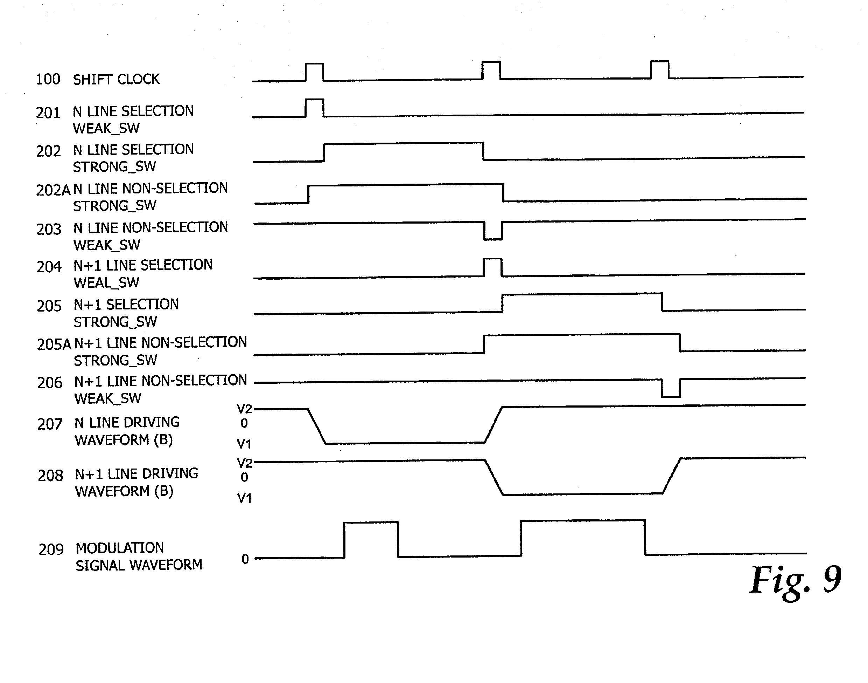

The modulation signal is described with reference to FIG. 9. Reference numeral 207 denotes a waveform of the scanning signal to be applied to the scanning wiring on line N, and reference numeral 208 denotes a waveform of the scanning signal to be applied to the scanning wiring on line N+1. A selection potential of minus dozen V to several dozen V is applied to lines to be selected for a predetermined period (for example, one horizontal scanning period). Reference numeral 209 denotes a waveform of the modulation signal to be applied to a certain modulation wiring. The modulation driving unit 6 outputs a modulation signal during a period (LOW period) at which the selection potential is applied to the scanning wirings. In this embodiment, the modulation signal having a pulse width modulation waveform of plus several dozen V is used. Normally, in the image display apparatus using the surface conduction type electron-emitting devices, the wider the pulse width is, the larger the integrated value of luminance becomes, and the brighter the device becomes. In the example of FIG. 9, therefore, the luminance of the display device on line N+1 is higher than that of the display device on line N.

### (Scan Driving Unit)

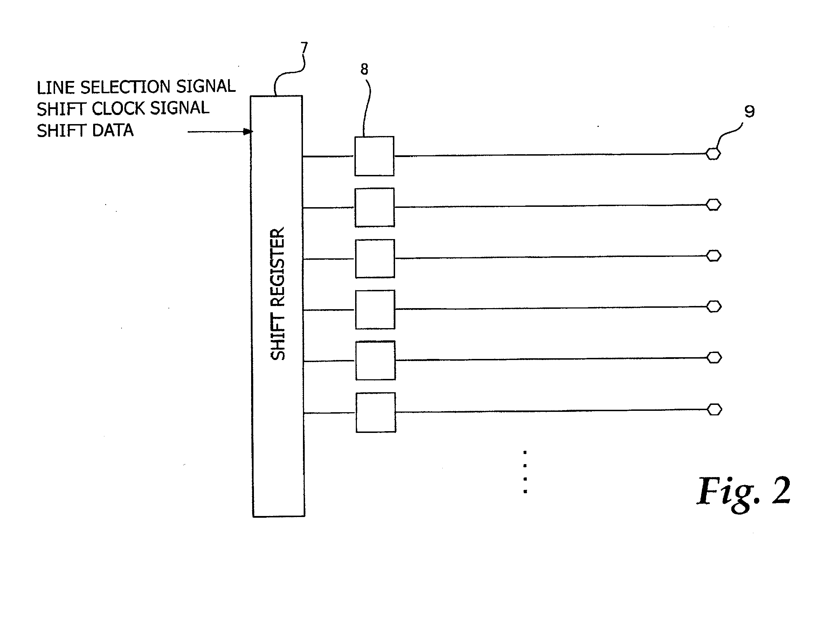

The constitution and the operation of the scan driving unit 5 are described concretely below. FIG. 2 is a block diagram of the scan driving unit 5. As shown in FIG. 2, the scan driving unit 5 has a shift register unit 7 and buffered switches 8.

The shift register unit 7 is a logic circuit which determines a line to be selected, and generates/outputs a control signal. The shift register unit 7 includes a shift register composed of D flip-flops, not shown, and a logic device which performs logical operations on outputs from the shift register, a shift clock, and outputs of shift data.

The buffered switches 8 are circuits which convert shift data (control signal) output from the shift register unit 7 into a voltage/electric current level necessary for driving the scanning wirings and output the converted data..

The scan driving unit 5 is, as described previously, required to suppress waveform disturbance (overshoot, undershoot, ringing and the like) of the driving voltage in order to apply an accurate voltage to the electron-emitting devices 3A. This point will be described.

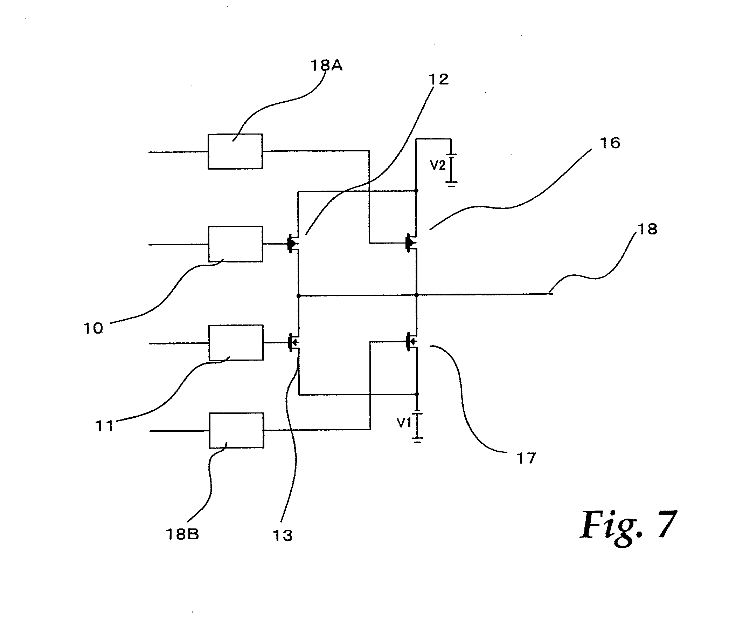

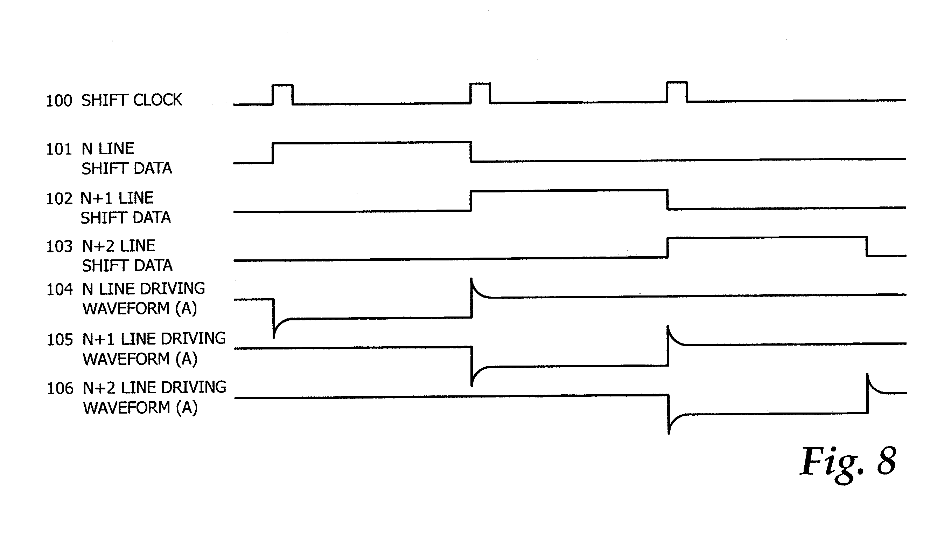

In the simplest constitution of the buffered switch, a P-channel field effect transistor (hereinafter, "P-ch MOSFET") 16 and an N-channel field effect transistor (hereinafter, "N-ch MOSFET") 17, shown in FIG. 7, switch the electric potentials of the scanning wirings. In FIG. 7, the P-ch MOSFET 16 is a switch for a non-selection potential V2, andN-chMOSFET 17 is a switch for a selection potential V1. Reference numerals 18A and 18B denote level shifters. As shown in FIG. 8, however, when the MOSFETs 16 and 17 are controlled by an n-line shift data 101 whose level is shifted, overshoot and undershoot are generated in a drive waveform (A) 104 of the scanning wirings.

Therefore, as shown in FIG. 7, conventionally switches of the high drive performance (strong drive performance P-ch MOSFET 16 and strong drive performance N-ch MOSFET 17) and switches of the low drive performance (weak drive performance P-ch MOSFET 12 and weak drive performance N-ch MOSFET 13) are combined. The switches of a low drive performance are used for a period during which the electric potential of the scanning wirings transit toward V1 or V2, and the switches of the high drive performance are used when the electric potential reaches V1 or V2.

The control signal at this time is described with reference to FIG. 9.

An N-line non-selection STRONG_SW signal 202A generated in the shift register unit is level-shifted by the level shifter 18A in FIG. 7, and the strong drive performance P-ch MOSFET 16 is turned off. An N-line selection WEAK_SW signal 201 is level-shifted by the level shifter 11, and the weak drive performance N-ch MOSFET 13 is turned on. As a result, the N-line drive waveform (B) 207 is dropped from the non-selection potential V2 to the selection potential V1. An N-line selection STRONG_SW signal 202 is level-shifted by the level shifter 18B, the strong drive performance N-ch MOSFET 17 is driven, and the N-line drive waveform (B) 207 is held at the selection potential V1. Then, anN-line non-selection WEAK_SW signal 203 is level-shifted by the level shifter 10, and the weak drive performance P-ch MOSFET 12 is turned on. As a result, the N-line drive waveform (B) 207 is returned to the non-selection potential V2. Such slew rate control enables the switching between the selection potential and the non-selection potential while waveform disturbance is being suppressed.

When, for example, the non-selection potential is 10 V and the selection potential is -15 V, a gate voltage of 5 to 10 V, for example, is necessary for controlling the strong drive performance P-ch MOSFET 16 and the weak drive performance P-ch MOSFET 12, which corresponds to the driving means for the non-selection potential. On the other hand, a gate voltage of -10 to -15 V, for example, is necessary for controlling the strong drive performance N-ch MOSFET 17 and the weak drive performance N-ch MOSFET 13, which corresponds to the driving means for the selection potential. Normally, the logic circuit such as the shift register uses a low logic voltage (for example, 3.3 V). Therefore, the voltage level should be shifted to a level at which a gate can be driven in order to use the output from the shift register as the control signals (gate driving signals) of the respective MOSFETs. Therefore, as shown in FIG. 7, conventionally the level shifters 18A, 18B, 10 and 11 are provided for the plurality of MOSFETs 16, 17, 12 and 13.

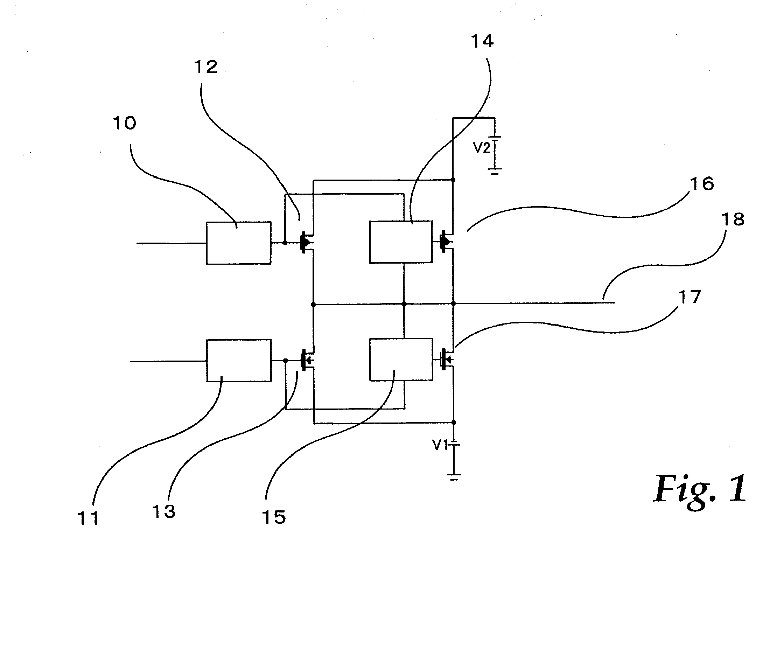

The level shifter can be realized by using a voltage-current converting circuit and a current-voltageconvertingcircuit. However, since the gate voltage is dozen V to several dozens V or minus dozen V to several dozens V, as mentioned previously, the circuits used in the level shifter should be high-voltage MOSs. In the case of the high-voltage MOS, its chip area becomes larger than that of CMOS. The number of level shifters should be equal to the number of output channels. For this reason, when the number of MOSFETs is increased as shown in FIG. 7 in order to suppress waveform disturbance, the number of the level shifters increases accordingly. As a result, the area of the IC chip becomes large. In order to solve such a problem, the buffered switch 8 having the constitution shown in FIG. 1 is adopted in the first embodiment.

### (Buffered Switch)

FIG. 1 illustrates the circuit configuration of the buffered switch 8. The buffered switch 8 has the weak drive performance N-ch MOSFET 13 (first driving means) and the strong drive performance N-ch MOSFET 17 (second driving means) which are connected in parallel as a driving means for the selection potential V1. The weak drive performance N-ch MOSFET 13 is a switch whose drive performance is lower (for example, ON-state resistance is higher) than that of the strong drive performance N-ch MOSFET 17, and is used for allowing the electric potentials of the scanning wirings to transit toward the selection potential V1 (first potential). The strong drive performance N-ch MOSFET 17 is a switch for maintaining the electric potentials of the scanning wirings at the selection voltage V1.

The buffered switch 8 also has the weak drive performance P-ch MOSFET 12 (third driving means) and the strong drive performance P-ch MOSFET 16 (fourth driving means) which are connected in parallel as the driving means for the non-selection potential V2. The weak drive performance P-ch MOSFET 12 is a switch whose drive performance is lower than that of the strong drive performance P-ch MOSFET 16, and is used for allowing the electric potentials of the scanning wirings to transit toward the non-selection potential V2 (second potential). The strong drive performance P-ch MOSFET 16 is a switch which maintains the electric potentials of the scanning wirings at the non-selection potential V2.

The level shifters 10 and 11 are connected to the gates of the weak drive performance P-ch MOSFET 12 and the weak drive performance N-ch MOSFET 13, respectively. The level shifters 10 and 11 are circuits for raising a voltage level of a control signal output from the shift register unit 7 (second control circuit). That is to say, the weak drive performance P-ch MOSFET 12 and the weak drive performance N-ch MOSFET 13 are controlled by the control signals whose levels have been shifted by the level shifters 10 and 11, respectively.

On the other hand, a self switch 14 for P-ch and a self switch 15 for N-ch (control circuits) are connected to gates of the strong drive performance P-ch MOSFET 16 and the strong drive performance N-ch MOSFET 17, respectively. The self switch 14 for P-ch is a circuit which outputs a control signal for controlling the strong drive performance P-ch MOSFET 16 according to an output 18 from the weak drive performance P-ch MOSFET 12. The self switch 15 for N-ch is a circuit which outputs a control signal for controlling the strong drive performance N-ch MOSFET 17 according to the output 18 from the weak drive performance N-ch MOSFET 13. That is to say, the strong drive performance P-ch MOSFET 16 and the strong drive performance N-ch MOSFET 17 are controlled not by an output from the shift register unit (logic circuit) but by outputs from the self switches provided in the buffered switch.

### (Constitution of Self Switch)

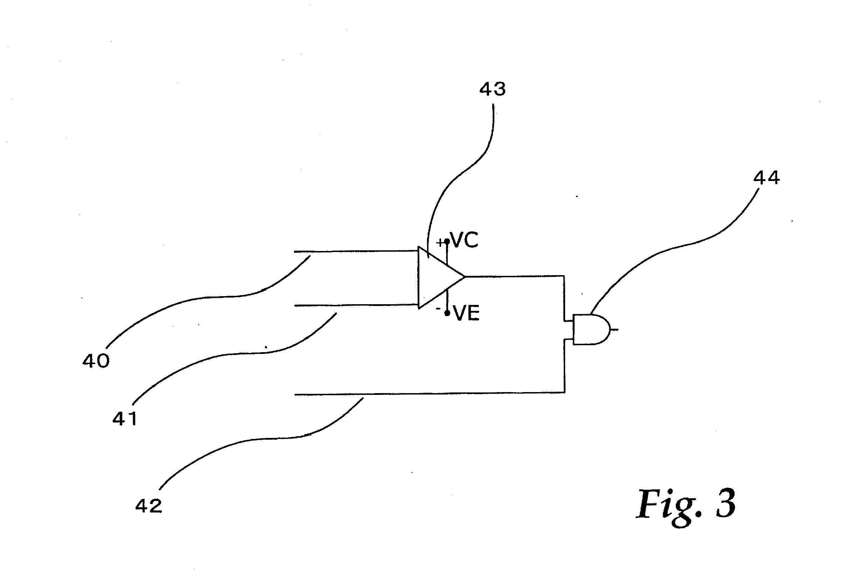

FIG. 3 illustrates a circuit configuration of the self switches. The self switch includes a voltage comparator 43 composed of an operational amplifier, and an AND gate circuit 44. The basic constitutions of the self switch 14 for P-ch and the self switch 15 for N-ch are the same.

One input 40 of the voltage comparator 43 is connected to the output 18 (see FIG. 1) of the weak drive performance MOSFET, and the other input 41 of the voltage comparator 43 is connected to a reference potential (REF). In the self switch 14 for P-ch on the non-selection potential V2 side, the reference potential REF is set to an electric potential lower than the non-selection potential V2 (for example, V2-1 volts). In the self switch 15 for N-ch on the selection potential V1 side, the reference potential REF is set to a potential higher than the selection potential V1 (for example, V1+1 volts).

VC and VE are power source terminals of the voltage comparator 43. Since the voltage comparator 43 treats input/output voltages which are equivalent to the selection potential V1 or the non-selection potential V2, power source voltages according to those are required. In this embodiment, VC is connected to GND, and VE is connected to a power source of selection potential V1 minus several V (for example, V1 minus 5 volts). In such a manner, the power source voltage (for example, 5 or more volts to not more than several dozens volts), which is higher than the power source voltage (for example, not less than several dozens millivolts to not more than 3.3 volts) to be supplied to the shift register unit, is supplied to the self switches.

One input of the AND gate circuit 44 is connected to the output of the voltage comparator 43 and the other input of the AND gate circuit 44 is connected to gates of the weak drive performance MOSFETs (output of level shifters). An output of the AND gate circuit 44 is connected to gates of the strong drive performance MOSFETs.

### (Operation of the Self Switch for P-ch)

An operation of the self switch 14 for P-ch is described concretely.

The weak drive performance P-ch MOSFET 12 is turned on by a control signal which is output from the shift register unit and whose level is shifted by the level shifter 10, and the potential of the output 18 rises toward the non-selection potential V2. The voltage comparator 43 of the self switch 14 for P-ch compares the potential of the output 18 with the reference potential REF (for example, V2 minus 1 volts). When the electric potential of the output 18 exceeds the reference potential REF, the voltage comparator 43 outputs an ON signal. The AND gate circuit 44 obtains AND of the output from the voltage comparator 43 and a signal obtained by inverting the output from the level shifter 10 (the gate voltage of the weak drive performance P-ch MOSFET 12). That is to say, when the weak drive performance P-ch MOSFET 12 is in the ON state, and the potential of the output 18 rises to nearly the non-selection potential V2 (target value) , a control signal is output from the AND gate circuit 44 to the strong drive performance P-ch MOSFET 16. As a result, the strong drive performance P-ch MOSFET 16 is turned on. The ON state of the strong drive performance P-ch MOSFET 16 is maintained by a latch circuit, not shown, until the weak drive performance N-ch MOSFET 13 is turned on.

### (Operation of the Self Switch for N-ch)

An operation of the self switch 15 for N-ch is described concretely.

The weak drive performance N-ch MOSFET 13 is turned on by a control signal which is output from the shift register unit and whose level is shifted by the level shifter 11, and the electric potential of the output 18 drops toward the selection potential V1. The voltage comparator 43 of the self switch 15 for N-ch compares the potential of the output 18 with the reference potential REF (for example, V1+1 volts). When the potential of the output 18 becomes lower than the reference potential REF, the voltage comparator 43 outputs an ON signal. The AND gate circuit 44 obtains AND of the output from the voltage comparator 43 and the output from the level shifter 11 (gate voltage of the weak drive performance N-ch MOSFET 13). That is to say, when the weak drive performance N-ch MOSFET 13 is in the ON state and the electric potential of the output 18 drops to nearly the selection potential V1 (target value), a control signal is output from the AND gate circuit 44 to the strong drive performance N-ch MOSFET 17. As a result, the strong drive performance N-ch MOSFET 17 is turned on. The ON state of the strong drive performance N-ch MOSFET 17 is maintained by the latch circuit, not shown, until the weak drive performance P-ch MOSFET 12 is turned on.

In a constitution using a conventional level shifter (FIG. 7), since the driving of the MOSFETs is controlled by the timing of the level shifters, high-speed and high accurate level shifters are necessary. On the contrary, in the constitution of this embodiment, the self switches automatically start the driving of the strong drive performance MOSFETs according to the output potential from the weak drive performance MOSFETs (namely, as the output potential reaches the target value). As a result, the MOSFETs can be driven at appropriate and accurate timing. Since requests for accuracy are reduced, the circuit can be simplified. Furthermore, since the number of level shifters can be greatly reduced, the area of the driving IC chip can be reduced. Since both the first and the second driving means are composed of the simple switches (MOSFETs), the circuit scale can be reduced.

The transition time of the potentials occasionally disperses depending on dispersion of an electrostatic capacity of the matrix panel and on dispersion of the performance of the MOSFETs. Conventionally, the period for switching from the weak drive performance MOSFET into the strong drive performance MOSFET should be set longer in consideration of the dispersion of the transition time. On the contrary, in this embodiment, since the self switches are used, the dispersion of the transition time does not have to be taken into consideration, so that the transition is enabled for the shortest time.

### <Second Embodiment>

In the first embodiment, the second driving means is composed of a switch, but in the second embodiment, the second driving means is composed of an amplifier and a switch (MOSFET). Characteristic of the second embodiment is that a voltage drop caused by ON-state resistance of MOSFET is corrected by a feedback amplifier. Even in such a constitution, controlling the second driving means by a self switch enables stable control of a large electric current with a reduced chip size. Since the other parts of the constitution except for the second driving means are similar to those in the first embodiment, characteristic parts of the constitution in the second embodiment are mainly described.

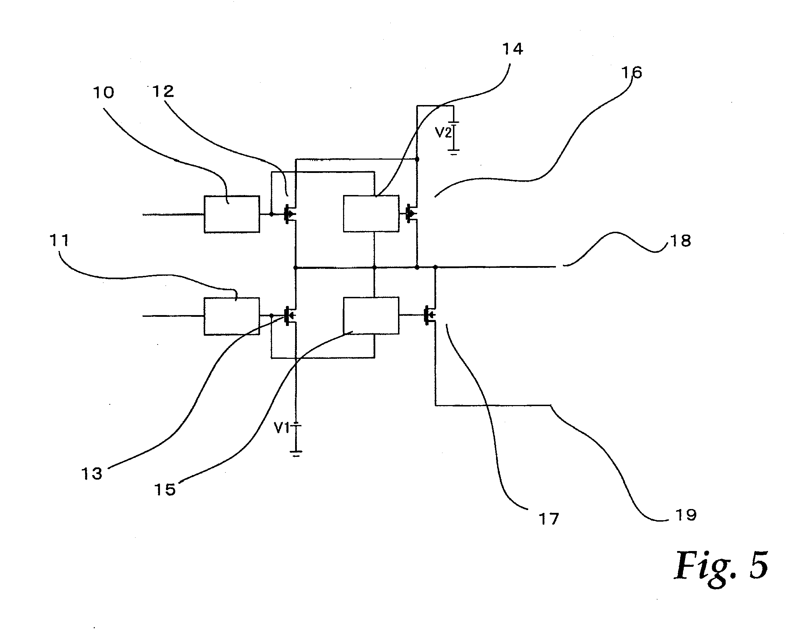

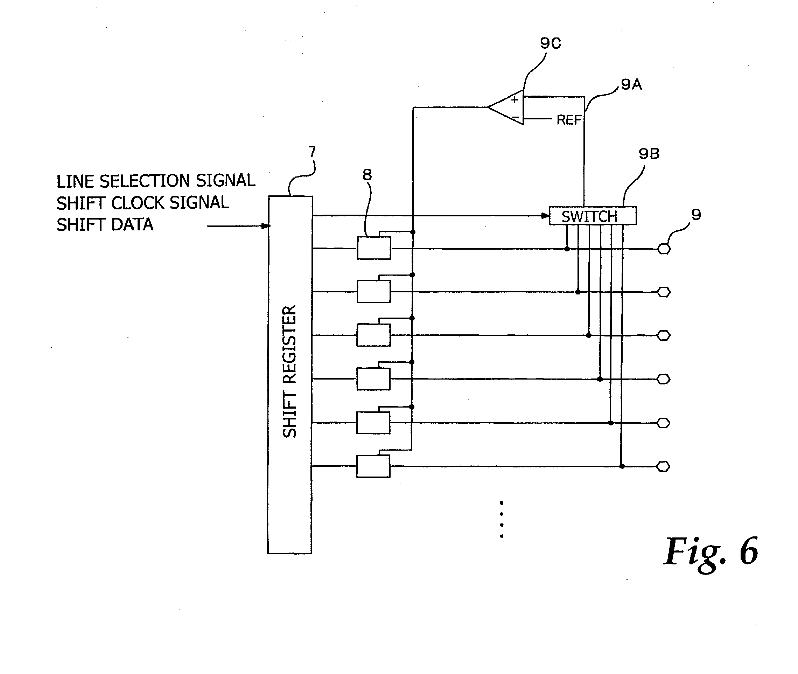

FIG. 6 is a block diagram illustrating a scan driving unit according to the second embodiment. FIG. 5 illustrates a circuit configuration of the buffered switch according to the second embodiment.

In the driving of the matrix panel, the maximum electric current flows when the scanning wirings are selected. That is to say, when the strong drive performance N-ch MOSFET 17 in FIG. 5 is turned on, the electric current flows maximally. In general, the MOSFET has ON-state resistance, and when the electric current is large, an influence of the voltage drop becomes non-negligible. Therefore, in this embodiment, a source potential of the strong drive performance N-ch MOSFET 17 is feedback-controlled based on an output potential to the scanning wirings, so that the voltage drop due to the ON-state resistance is corrected.

As shown in FIGS. 5 and 6, the output 18 of the buffered switch 8 is connected to an output pad (IC driving output) 9 of the scan driving circuit. A feedback switch 9B is a circuit that selects which IC driving output (output pad) 9 to be connected to an input 9A of an amplifier 9C based on a signal from the shift register unit 7. A potential of a selected line (scanning wiring) is fed back to the amplifier 9C. The selection potential V1 is connected as a reference potential to the other input of the amplifier 9C. An output of the amplifier 9C is connected to a source of the strong drive performance N-ch MOSFET 17 in the buffered switch 8. The amplifier 9C is composed of an operational amplifier and a buffered circuit for increasing the drive performance.

In the buffered switch 8 on a selected line, the weak drive performance N-ch MOSFET 13 is driven by a control signal from the shift register, and output potential drops toward V1. When the output potential reaches a predetermined value (for example, V1+1 volts), the self switch 15 for N-ch turns on the strong drive performance N-ch MOSFET 17. At this time, since the voltage drops due to the ON-state resistance of the strong drive performance N-ch MOSFET 17, the output potential does not match with the selection potential V1. Therefore, the output potential on the selected line is input into the amplifier 9C via the feedback switch 9B. The amplifier 9C outputs a voltage according to a difference between the output potential and the selection potential V1 (namely, an amount of voltage drop). The amplifier output is fed back to a source of the strong drive performance N-ch MOSFET 17, and the output potential is adjusted. Such feedback control compensates the voltage drop, and suitably maintains the output potential at the selection potential V1.

### <Third Embodiment>

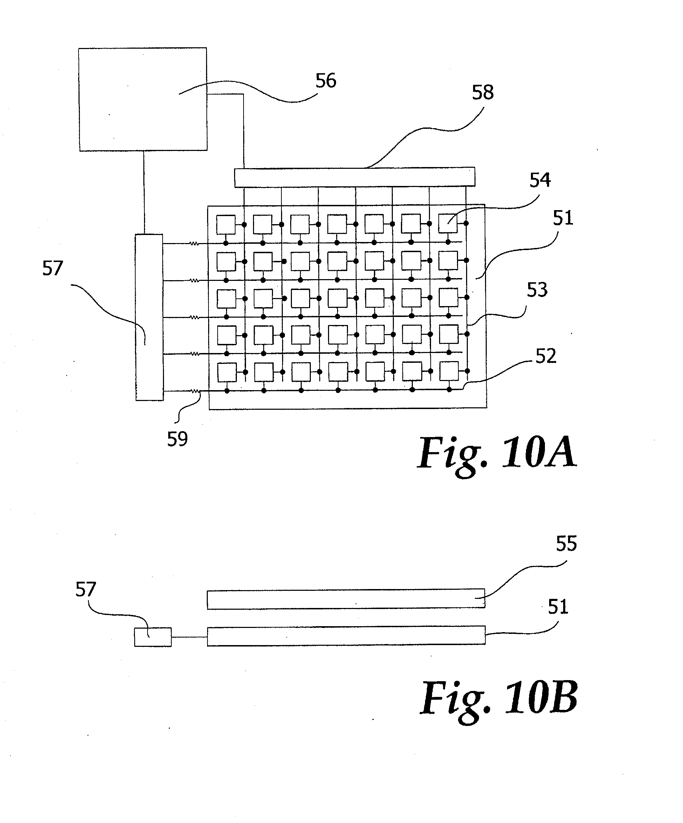

In the first and second embodiments, the scan driving unit 5 drives the matrix panel of the image display apparatus, but in a third embodiment, the scan driving unit 5 drives an LED backlight of a liquid crystal display apparatus. As a result, while luminance irregularity of the backlight is being suppressed, sequential driving of lines at a low price is enabled. FIGS. 10A and 10B are diagrams illustrating a constitution for driving the LED backlight of the liquid crystal display apparatus, FIG. 10A is a plan view, and FIG. 10B is a cross-sectional view.

The LED backlight of the liquid crystal display apparatus has an LED matrix 51, a control unit 56, a line driving unit 57 and a column driving unit 58. The line driving unit 57 and the column driving unit 58 are respectively composed of an IC (integrated circuit).

The LED matrix 51, in which a plurality of LED blocks 54 (LEDs are connected in series) is arranged, emits light toward a liquid crystal panel 55 from the back of it so that a desired image is displayed.

The LED blocks 54 on the LED matrix 51 are matrix-driven by line selection wirings 52 and column selection wirings 53. The line selection wirings 52 are respectively connected to output terminals of the line driving unit 57 via resistances 59. The column selection wirings 53 are respectively connected to output terminals of the column driving unit 58.

The control unit 56 controls the line driving unit 57 and the column driving unit 58, and applies a driving voltage of several dozen volts, for example, between the line selection wirings 52 and the column selection wirings 53 via the resistances 59. As a result, the LED blocks 54 emit light. The LED blocks emit light according to a video on the liquid crystal panel 55, so that bright portions of the screen emit light brightly, and dark portions of the screen emit light slightly. As a result, luminance control (local dimming) according to the video is enabled.

In this embodiment, the control unit 56 controls the timing for switching the column selection wirings 53, the selection time, and the timing at which a voltage is applied to the line selection wirings 52. As a result, the luminance control is made in synchronization with the video.

The brightness obtained by the light emission of the LED blocks 54 is determined by applied voltages to the LED blocks 54 (applied currents to the LED blocks 54 controlled by the resistances 59). Therefore, in order to obtain the accurate luminance characteristics without dispersion, the stabilization of the driving voltage (driving current) of the LED blocks 54, namely, prevention of the waveform disturbance of the drive voltage (overshoot, undershoot, ringing and the like) becomes important.

### (Driving Unit)

The line driving unit 57 is a drive circuit which selects one or a plurality of line selecting wirings 52. The line driving unit 57 applies a selection potential of minus several dozen V to the line selection wirings 52 to be selected, and applies a GND potential to the other line selection wirings 52. The line selection wirings 52 to be selected are sequentially switched, so that the selection of the LED blocks 54 in a vertical direction is realized. The line driving unit 57 is composed of an integrated circuit.

The column driving unit 58 is a drive circuit which selects the column selection wirings 53 based on an input image signal, controls selection time and controls an amount of light emission of the respective LED blocks 54.

In the above constitution, the line driving unit 57 and the column driving unit 58 are realized by using the circuit configurations of the scan driving unit 5 and the modulation driving unit 6 in the first and second embodiments. As a result, overshoot, undershoot and ringing can be repressed. Thus, since the voltage (electric current) and the time for applying to the LED blocks 54 can be accurately controlled, the accurate luminance control is achieved, and the high-definition video display is achieved.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

A drive circuit, which drives a display panel having wirings and display devices to be connected to the wirings, has first driving means that allows a potential of the wirings to transit toward the first potential, second driving means that maintains the potential of the wirings at the first potential, and a control circuit that outputs the control signal for controlling the second driving means according to an output of the first driving means. As a result, a plurality of driving means can be controlled at appropriate timing in a simple structure.

## Claims

1. A drive circuit of a display panel which drives display panel having wirings and display devices connected to the wirings, comprising:
first driving means that allows a potential of the wirings to transit toward a first potential;
second driving means that maintains the potential of the wirings at the first potential; and
a control circuit that outputs a control signal for controlling the second driving means according to an output from the first driving means.

2. A drive circuit of a display panel according to claim 1, wherein both the first driving means and the second driving means are switches.

3. A drive circuit of a display panel according to claim 1, wherein the second driving means has an amplifier that corrects voltage drop of the wirings.

4. A drive circuit of a display panel according to claim 1,
wherein the wirings are scanning wirings to which a scanning signal for matrix-driving of the display devices is applied,
and wherein the display panel has modulation wirings to which a modulation signal for matrix-driving of the display devices is applied.

5. A drive circuit of a display panel according to claim 1, further comprising:
third driving means that allows the potential of the wirings to transit toward a second potential different from the first potential;
fourth driving means that maintains the potential of the wirings at the second potential; and
a circuit which outputs a control signal for controlling the fourth driving means according to an output of the third driving means.

6. A drive circuit of a display panel according to claim 1, wherein the control circuit that outputs the control signal for controlling the second driving means comprises a voltage comparator and a gate circuit.

7. A drive circuit of a display panel according to claim 1, further comprising:
a second control circuit that outputs a control signal for controlling the first driving means; and
a level shifter that raises a voltage level of the control signal output from the second control circuit,
wherein a power source voltage higher than a power source voltage to be supplied to the second control circuit is supplied to the control circuit that outputs the control signal for controlling the second driving means.

8. A drive circuit of a display panel according to claim 7, wherein
the power source voltage to be supplied to the second control circuit is not more than 3.3 volts,
the power source voltage to be supplied to the control circuit for outputting the control signal which controls the second driving means is not less than 5 volts.

9. A display apparatus, comprising:
the drive circuit according to claim 1; and
a display panel that is driven by the drive circuit.
